# EUROPÄISCHE PATENTSCHRIFT

(11) **EP 1 080 503 B1**
(45) Veröffentlichungstag und Bekanntmachung des Hinweises auf die Patenterteilung: **06.12.2006**
(21) Anmeldenummer: 99927668.6
(22) Anmeldetag: 15.04.1999
(51) Int. Cl.: H01L 41/047, H01L 41/09

(54) **PIEZOELEKTRISCHER BIEGEWANDLER UND MODUL AUS EINER ANZAHL VON PIEZOELEKTRISCHEN BIEGEWANDLERN**
PIEZOELECTRIC BENDING TRANSDUCER AND A MODULE MADE OF A PLURALITY OF PIEZOELECTRIC BENDING TRANSDUCERS
CAPTEUR PIEZOELECTRIQUE DE FLEXION ET MODULE CONSTITUE D'UNE PLURALITE DE CAPTEURS PIEZOELECTRIQUES DE FLEXION

(30) Priorität: 24.04.1998 DE 19818449
(43) Veröffentlichungstag der Anmeldung: 07.03.2001
(73) Patentinhaber: Argillon GmbH, 96257 Redwitz (DE)
(72) Erfinder: GÜNTHER, Jürgen, D-96342 Stockheim (DE); KLUMP, Stefan, D-96215 Lichtenfels (DE); RIEDEL, Michael, D-96489 Niederfüllbach (DE)
(74) Vertreter: Tergau & Pohl Patentanwälte
(86) Internationale Anmeldenummer: PCT/DE1999/001132
(87) Internationale Veröffentlichungsnummer: WO 1999/056328

(56) Entgegenhaltungen:
- EP-A- 0 366 847

## Beschreibung

Die Erfindung betrifft einen piezoelektrischen Biegewandler mit einem flachen Tragkörper und einer darauf zumindest einseitig aufgebrachten piezoelektrisch aktiven Beschichtung mit einer inneren, dem Tragkörper zugewandten Kontaktfläche und einer äußeren, dem Tragkörper abgewandten Kontaktfläche. Die Erfindung betrifft weiterhin ein Modul aus einer Anzahl von derartigen piezoelektrischen Biegewandlern.

Ein piezoelektrischer Biegewandler der eingangs genannten Art dient vorrangig zur Ausnutzung des indirekten oder reziproken piezoelektrischen Effekts, d.h. der Umwandlung von elektrischer in mechanische Energie. Gleichwohl eignet sich ein derartiges piezoelektrisches Element aber auch dazu, mechanische in elektrische Energie umzuwandeln. Hierbei wird der direkte piezoelektrische Effekt ausgenutzt.

Für einen piezoelektrischen Biegewandler gibt es eine Vielzahl von technischen Anwendungen. Solche Anwendungen sind z.B. als ein piezoelektrischer Druckkopf für einen Tintenstrahldrucker, als ein Sensor für die Beschleunigungs- oder Druckmessung, als Stellelement für die Weitergabe der Musterinformation in einer Web-, Wirk- oder Strickmaschine und als ein Stellelement in einer Braille-Zeile in einem Lesegerät für Blinde, in einem Pneumatikventil, in einem schreibenden Meßgerät oder in einem berührungslosen Oberflächen-Meßinstrument.

Das Anlegen einer Spannung zwischen der äußeren und der inneren Kontaktfläche führt je nach Polung zu einer Kontraktion oder einer Expansion der piezoelektrischen Beschichtung, so daß sich der gesamte Biegewandler verbiegt oder daß bei festgehaltenem einen Ende des Biegewandlers das andere Ende definiert ausgelenkt wird. Entsprechend umgekehrt wird eine Spannung zwischen der inneren und der äußeren Kontaktfläche erzeugt, wenn der Biegewandler durch einen mechanischen Einfluß gegenüber seiner gestreckten Ruheposition verbogen wird.

Ein Biegewandler der eingangs genannten Art ist beispielsweise aus der DE 195 20 796 A1, der DE 40 25 436 A1 oder der DE 196 20 826 B1 bekannt.

Ein Modul der eingangs genannten Art mit einer Anzahl von piezoelektrischen Biegewandlern wird dazu verwendet, ein elektronisches Informationssignal in ein mechanisch abtastbares Informationssignal umzuwandeln. Beispielsweise wird ein Modul mit einer Vielzahl von parallel angeordneten elektrischen Biegewandlern zum Ansteuern der Nadeln oder der maschenbildenden Elementen einer Web-, Wirk- oder Strickmaschine verwendet. Zur Musterbildung in der von einer Textilmaschine erzeugten Ware wird dabei die Information, ob eine Masche gebildet wird oder nicht über eine mechanische Abtastung der Auslenkung des entsprechenden piezoelektrischen Biegewandlers erhalten. Ein derartiges Steuermodul ist beispielsweise aus der US 3,961,501 A oder der EP 0 210 790 A2 bekannt.

Sowohl bei einem piezoelektrischen Biegewandler als auch bei einem Modul mit einer Anzahl von piezoelektrischen Biegewandlern stellt sich das Problem der elektrischen Kontaktierung der Kontaktflächen der piezoelektrischen Beschichtung. Bislang ist es hierzu aus der DE 40 25 436 A1 bekannt, die äußere Kontaktfläche der piezoelektrischen Beschichtung in Form einer dünnen Metallschicht auszubilden, und zum elektrischen Anschluß einen entsprechenden Anschlußdraht auf die Metallschicht aufzulöten. Für die Kontaktierung der inneren Kontaktfläche ist es aus demselben Dokument bekannt, zwischen dem Tragkörper und der piezoelektrischen Beschichtung ein Metallplättchen einzulegen und auf dieses dann einen Anschlußdraht aufzulöten.

Die elektrische Kontaktierung der Kontaktflächen erfolgt also über einen Lötkontakt und einen entsprechenden Anschlußdraht.

Nachteiligerweise stellt jedoch das Anlöten eines Anschlußdrahtes an ein verhältnismäßig kleines Bauteil wie einen piezoelektrischen Biegewandler eine nur schwer zu automatisierende Tätigkeit dar. Dies führt zu nachteilig hohen Produktionskosten. Auch stellt für einen piezoelektrischen Biegewandler und insbesondere für ein Modul aus einer Anzahl von piezoelektrischen Biegewandlern, für welches eine hohe Ausfallsicherheit gefordert wird, sowohl der Lötkontakt als auch der Anschlußdraht eine zusätzliche Ausfallkomponente dar, was die Ausfallsicherheit des Biegewandlers und damit insbesondere die des Moduls verschlechtert. Zudem gestaltet sich der Austausch eines eingebauten Biegewandlers oder eines eingebauten Moduls mit einem herkömmlichen elektrischen Anschluß mittels Lötkontakt relativ aufwendig.

Weiter wird in der DE 36 34 484 A1 vorgeschlagen, einen piezoelektrischen Wandler über einen Leitgummi elektrisch anzuschließen. Hierzu wird der Leitgummi zwischen ein Gehäuse und dem Wandler dauerhaft eingespannt.

In der EP-A-0 366 847 ist ein bimorpher piezoelektrischer. Wandler in einem optischen Modulator eingesetzt. Der optische Modulator weist eingangsseitig und ausgangsseitig jeweils einen Lichtwellenleiter auf. Freie Enden der Lichtwellenleiter liegen in dem Modulator unter Bildung eines Spalts einander gegenüber, wobei der piezoelektrische Wandler in spannungslosem Zustand innerhalb des Spalts angeordnet ist und dadurch den Lichtweg vom Eingangswellenleiter zum Ausgangswellenleiter blockiert. Bei Ansteuerung des Wandlers mit einer Steuerspannung gibt dieser den Spalt frei und ermöglicht somit die optische Kopplung von Eingangswellenleiter, d.h. die Freigabe des Lichtwegs durch den Modulator. Zur Kontaktierung der metallisierten piezoelektrischen Struktur kommt wird ein elektrisch leitfähiger Streifen, beispielsweise aus einem homogenen elektrisch leitfähigen Elastomer verwendet.

Aufgabe der Erfindung ist es, einen piezoelektrischen Biegewandler der genannten Art anzugeben, welcher eine besonders einfache elektrische Kontaktierung der Kontaktflächen erlaubt. Ferner ist es Aufgabe der Erfindung, ein Modul mit einer Anzahl von piezoelektrischen Biegewandlern anzugeben, wobei die elektrische Kontaktierung der einzelnen Biegewandler problemlos möglich ist. Auch soll insgesamt eine hohe Ausfallsicherheit für einen piezoelektrischen Biegewandler und für ein Modul aus piezoelektrischen Biegewandlern erzielt werden.

Die Aufgabe bezüglich des piezoelektrischen Biegewandlers wird erfindungsgemäß dadurch gelöst, daß dieser zur Kontaktierung einer Kontaktfläche einen elektrischen Steckkontakt mit einem die Kontaktfläche berührenden elektrisch leitfähigen Elastomer aufweist, welches für eine lösbare Aufnahme eines Kontaktstiftes durch plastische Verformung ausgebildet ist.

Die Berührung des Elastomers mit der Kontaktfläche kann dabei punktuell oder aber auch flächig ausgebildet sein. Durch das Einführen oder Einstecken des Kontaktstiftes in das Elastomer wird eine elektrisch leitfähige Verbindung zwischen dem Kontaktstift und der das Elastomer berührenden Kontaktfläche hergestellt. Infolge der reversiblen Deformierbarkeit des Elastomers kann der Kontaktstift wiederholt in das Elastomer eingesteckt und herausgezogen werden, ohne daß es zu einer Verschlechterung der elektrischen Verbindung zwischen Kontaktstift und Kontaktfläche kommt.

Die Erfindung bietet den Vorteil einer sicheren elektrischen Kontaktierung der Kontaktflächen des piezoelektrischen Biegewandlers ohne daß hierfür zusätzliche Ausfallkomponenten, wie Lötkontakt oder Anschlußdraht notwendig wären. Durch die reversible Verformbarkeit des Elastomers ist zudem eine sichere und lösbare elektrische Verbindung über einen Kontaktstift gegeben.

Gleichzeitig erlaubt die Erfindung einen problemlosen Austausch eines defekten piezoelektrischen Biegewandlers. Zusätzlich beansprucht die erfinderische Kontaktierung weniger Bauraum als eine vergleichbare Kontaktierung mittels Verlötung gemäß Stand der Technik. Auch erlaubt das Anbringen eines Elastomers an einer Kontaktfläche des piezoelektrischen Biegewandlers ein Automatisieren des Herstellungsprozesses. Die Kontaktfläche muß dabei einfach in das Elastomer eingesteckt oder aber das Elastomer auf die Kontaktfläche gepreßt, gedrückt oder geklebt werden.

In vorteilhafter Ausgestaltung der Erfindung ist das eine Ende des piezoelektrischen Biegewandlers fest mit einem Anschlußsockel verbunden, wobei das Elastomer eine Bohrung oder eine Aussparung des Anschlußsockels ausfüllt, wobei das Elastomer zum Einstecken des Kontaktstiftes eine frei zugängliche Oberfläche aufweist und wobei zumindest ein Teil der Wandung der Bohrung oder der Aussparung durch einen Teil der Kontaktfläche gebildet ist. Die Bohrung oder die Aussparung in dem Anschlußsockel kann beispielsweise als ein Sackloch ausgebildet sein, in welches das Elastomer in flüssigem Zustand eingegossen wird. Dadurch, daß ein Teil der Wandung der Bohrung oder der Aussparung durch einen Teil der Kontaktfläche selbst gebildet wird, berührt das Elastomer nach Aushärtung die Kontaktfläche und steht damit in leitfähiger Verbindung mit dieser. Zur Herstellung eines derartigen Steckkontaktes wird beispielsweise der Biegewandler in einen Längsschlitz des Anschlußsockels eingeschoben, wobei an einer Stelle des Längsschlitzes eine seitliche Aussparung vorgesehen ist. Diese Aussparung wird anschließend mit dem Elastomer aufgefüllt, und das Elastomer wird ausgehärtet. Der Anschlußsockel selbst ist hierbei aus einem elektrisch isolierenden Material, beispielsweise aus einem Kunststoff, ausgebildet.

Vorteilhafterweise ist das Elastomer ein Silikonkautschuk mit eingelagerten metallischen Partikeln, insbesondere Silber. Silikonkautschuk gestattet eine einfache Handhabung in flüssigem Zustand und zeigt nach Aushärtung eine hervorragende reversible Verformbarkeit. Entsprechende Versuche haben gezeigt, daß die Kontaktierung der Kontaktfläche auch nach über 50-maligem Lösen und Einstecken des Kontaktstiftes unbeeinflußt war. Insbesondere das Einlagern von Silber gewährleistet eine hohe elektrische Leitfähigkeit des Silikonkautschuks.

In einer alternativen Ausgestaltung der Erfindung ist das Elastomer ein leitfähiger Kunststoffschaum. Ein derartiger Kunststoffschaum wird beispielsweise als Verpackungsmaterial zum Schutz von elektromagnetischen Einwirkungen für hochempfindliche elektronische Geräte verwendet. Im Falle des Elastomers Kunststoffschaum kann die Verarbeitung einfach durch Zuschneiden des Kunststoffschaumes erfolgen.

In einer weiteren vorteilhaften Ausgestaltung der Erfindung weist die äußere und die innere Kontaktfläche den elektrischen Steckkontakt mit einem Elastomer auf, wobei sich die innere Kontaktfläche zusammen mit dem Tragkörper über die Beschichtung hinaus in Längsrichtung des Tragkörpers in den Anschlußsockel erstreckt, und dort über das Elastomer kontaktierbar ist. Dies erlaubt eine räumliche Trennung des elektrischen Anschlusses von innerer und äußerer Kontaktfläche des piezoelektrischen Biegewandlers. Insbesondere dadurch, daß die innere Kontaktfläche mit dem Tragkörper ohne Beschichtung in das Anschlußstück hinein fortgeführt ist, kann auch die Kontaktierung der inneren Kontaktfläche über ein die Kontaktfläche berührendes Elastomer in einfacher Art und Weise ausgeführt werden.

Weiter von Vorteil ist es, wenn der piezoelektrische Biegewandler beidseitig mit der piezoelektrisch aktiven Beschichtung mit jeweils einer äußeren Kontaktfläche versehen ist. Ein derartiger Biegewandler erlaubt eine Verbiegung in zwei entgegengesetzte Richtungen mit einer hohen Stellkraft.

Für die Kontaktierung der inneren Kontaktfläche ist es zweckmäßig, wenn der Tragkörper selbst aus einem elektrisch leitfähigen Material besteht und selbst die innere Kontaktfläche bildet. Für die Kontaktierung der inneren Kontaktfläche braucht hierbei nur das elektrisch leitfähige Elastomer den Tragkörper zu berühren.

Bezüglich des Moduls mit einer Anzahl von piezoelektrischen Biegewandlern wird die Aufgabe erfindungsgemäß dadurch gelöst, daß die einen Enden der Biegewandler in einer gemeinsamen Anschlußleiste zusammengefaßt sind, und daß zur Kontaktierung der Kontaktflächen ein elektrischer Steckkontakt mit einem die jeweilige Kontaktfläche berührenden, in einer Bohrung oder Aussparung der Anschlußleiste angeordneten Elastomer aufweist, welches für eine lösbare Aufnahme eines Kontaktstiftes durch plastische Verformung ausgebildet ist.

Das Modul erlaubt eine sichere Kontaktierung der Biegewandler über eine entsprechende Anschlußleiste mit Kontaktstiften, die in die jeweiligen mit einem Elastomer ausgefüllten Bohrungen oder Aussparungen eingedrückt werden. Durch die lösbare Verbindung kann das Modul als Ganzes rasch ausgetauscht und durch ein anderes ersetzt werden, ohne daß hierfür schwierig auszuführende Arbeiten notwendig wären.

In einer vorteilhaften Ausführungsform weist das Modul beidseitig mit jeweils einer Piezokeramik beschichtete Biegewandler auf, wobei die Polarisationsrichtungen der Piezokeramiken eines Biegewandlers jeweils in die gleiche Richtung und die Polarisationsrichtungen einander zugewandter Piezokeramiken benachbarter Biegewandler in entgegengesetzte Richtungen zeigen, wobei die einander zugewandten äußeren Kontaktflächen der Piezokeramiken benachbarter Biegewandler gemeinsam mit einem Elastomer kontaktiert sind.

Dadurch, daß die Polarisationsrichtungen der Piezokeramiken eines Biegewandlers in die gleiche Richtung zeigen, kann der Biegewandler durch Anlegen entsprechender Steuerspannungen in zwei entgegengesetzte Richtungen ausgelenkt werden, ohne daß hierbei eine der Piezokeramiken entgegen ihrer Polarisationsrichtung betrieben wird. Hierzu wird in Polarisationsrichtung der beiden Piezokeramiken zwischen die äußeren Kontaktflächen eine vorgegebene Betriebsspannung (in der Regel sind dies etwa 200 V) und an die elektrisch miteinander kontaktierten inneren Kontaktflächen abwechselnd das Potential der einen und das Potential der anderen äußeren Kontaktfläche angelegt. Auf diese Weise kontrahieren abwechselnd die beiden Piezokeramiken und führen zu einer Auslenkung des freien Endes des Biegewandlers einmal in die eine und einmal in die andere Richtung. Die elektrische Kontaktierung der inneren Kontaktflächen miteinander kann beispielsweise über einen elektrisch leitfähigen Tragkörper geschehen.

Werden derartige Biegewandler in dem Modul abwechselnd mit zueinander entgegengesetzten Polarisationsrichtungen angeordnet, so können die einander zugewandten äußeren Kontaktflächen der Piezokeramiken benachbarter Biegewandler auf dasselbe Potential gelegt werden. Für den elektrischen Anschluß wird hierfür ein Elastomer, welches jeweils zwischen die äußeren Kontaktflächen gelegt ist, verwendet. Eine derartige Anordnung bietet den großen Vorteil, daß die Biegewandler in dem Modul dicht aufeinanderfolgend angeordnet werden können. Pro Fläche können daher zur Informationsweitergabe mehr Biegewandler zur Verfügung gestellt werden. Auch weist ein derartiges Modul durch die Betriebsweise der Biegewandler nur in Polarisationsrichtung der Piezokeramik und durch die Verringerung der Zahl elektrischen Anschlüssen eine hohe Betriebssicherheit und eine niedrige Ausfallquote auf.

Vorteilhafterweise besteht jeder Tragkörper aus einem elektrisch leitfähigem Material, erstreckt sich über die Beschichtung hinaus in die Anschlußleiste und weist dort den elektrischen Steckkontakt in Form des Elastomers auf. Ein elektrisch leitfähiges Material kann beispielsweise ein Metall oder aber auch ein elektrisch leitfähiger Kunststoff, wie insbesondere ein mit Kohlefasern verstärktes Epoxidharz sein. Ist der Tragkörper aus einem elektrisch leitfähigen Material, so ist für die Kontaktierung der inneren Kontaktflächen jedes Biegewandlers lediglich ein elektrischer Anschluß erforderlich. Durch die Verlängerung des Tragkörpers ohne Beschichtung in die Anschlußleiste hinein, kann der elektrische Anschluß für die inneren Kontaktflächen räumlich getrennt von den elektrischen Anschlüssen der äußeren Kontaktflächen getrennt werden. Zudem erhält der gesamte Biegewandler durch den verlängerten Tragkörper eine höhere mechanische Stabilität in der Anschlußleiste. Für eine besonders gute Kontaktierung mit dem Elastomer kann der Tragkörper auf der dem Elastomer zugewandten Seite mit einer Belegung aus einer Kupferfolie versehen sein.

Ausführungsbeispiele der Erfindung werden anhand einer Zeichnung näher erläutert. Darin zeigen:
- FIG 1: einen piezoelektrischen Biegewandler mit einem Anschlußsockel, welcher drei elektrische Steckkontakte mit einem Elastomer aufweist, und einen für das Anschlußstück ausgebildeten Stecker;
- FIG 2: ein Modul aus sechzehn parallel angeordneten piezoelektrischen Biegewandlern, welche in einer gemeinsamen Anschlußleiste zusammengefaßt sind, und wobei die elektrischen Anschlüsse für die Biegewandler jeweils als Steckkontakte mit einem Elastomer ausgebildet sind; und
- FIG 3: ein modular aufgebautes Steuermodul zum Ansteuern der Nadeln einer Rundstrickmaschine mit einem Gehäuseteil, einem Biegewandlermodul und einer Elektronikplatine, wobei die elektrische Verbindung zwischen der Elektronikplatine und dem Biegewandlermodul lösbar über in Steckkontakte eingreifende Kontaktstifte ausgebildet ist.

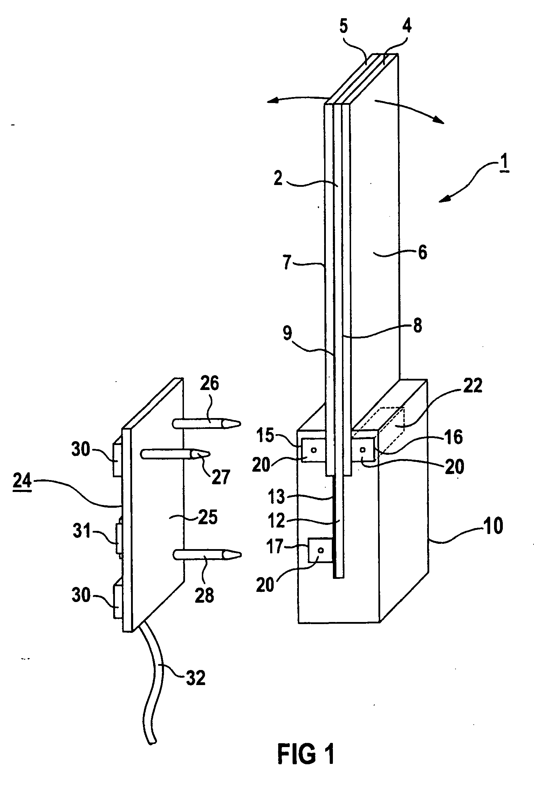

In FIG 1 ist ein piezoelektrischer Biegewandler 1 mit einem flachen Tragkörper 2 und einer darauf beidseitig aufgebrachten piezoelektrischen Beschichtung 4 und 5 gezeigt. Der Tragkörper 2 besteht aus einem elektrisch leitfähigen, mit Kohlefasern verstärkten Epoxidharz. Als piezoelektrische Beschichtung 4 und 5 ist eine Piezokeramik auf Basis von Blei-Zirkonat-Titan aufgebracht. Jede der piezoelektrischen Beschichtungen 4 und 5 weist eine äußere Kontaktfläche 6 bzw. 7 sowie eine innere Kontaktfläche 8 bzw. 9 auf. Sowohl die äußeren Kontaktflächen 6 und 7 als auch die inneren Kontaktflächen 8 und 9 sind in Form einer dünnen metallischen Beschichtung ausgebildet. Die inneren Kontaktflächen 8 und 9 stehen mit dem Tragkörper 2 in elektrischem Kontakt.

Zum Anschluß an eine Steuerspannung umfaßt der piezoelektrische Biegewandler 1 an seinem einen Ende einen Anschlußsockel 10. Das andere Ende des piezoelektrischen Biegewandlers 1 ist frei beweglich. Tragkörper 2 und piezoelektrische Beschichtung 4 und 5 sind in eine entsprechende Aussparung des Anschlußsockels 10 gesteckt und mit diesem fest verklebt. Der Anschlußsockel 10 selbst besteht aus einem elektrisch isolierenden Kunststoff und ist im Spritzgußverfahren hergestellt. Für eine gute mechanische Verbindung und eine einfach elektrische Kontaktierung ist der Tragkörper 2 über die piezoelektrische Beschichtung 4 und 5 hinaus in den Anschlußsockel 10 verlängert. Zusätzlich ist das sich in dem Anschlußsockel 10 befindliche freie Ende 12 des Tragkörpers 2 einseitig mit einer Kupferbelegung 13 versehen.

Die äußeren Kontaktflächen 6 und 7 sind jeweils über einen elektrischen Steckkontakt 15 bzw. 16 an eine externe Spannungsquelle anschließbar. Ebenso weist der elektrisch leitfähige Tragkörper 2 zum Anschluß an einen Pol einer externen Spannungsquelle einen elektrischen Steckkontakt 17 auf. Jeder elektrische Steckkontakt 15, 16 und 17 ist als ein in den Anschlußsockel 10 eingearbeitetes Sackloch 22 ausgebildet, welches mit einem elektrisch leitfähigen Elastomer 20 ausgefüllt ist. Das Elastomer 20 ist ein Silikonkautschuk, welches eingelagerte Silberpartikel umfaßt. Das Silikonkautschuk wird in flüssiger Form in das Sackloch 22 eingefüllt und härtet anschließend aus. Das Sackloch 22 ist im wesentlichen quaderförmig ausgebildet, wobei die Wand einer Längsseite durch einen Teil der zu kontaktierenden Fläche selbst gebildet ist. Auf diese Weise ist eine flächige Berührung des Elastomers 20 mit der zu kontaktierenden Fläche und damit eine sichere elektrische Verbindung gewährleistet. Im Anschlußsockel 10 ist das Elastomer 20 des Steckkontaktes 17 mit der Kupferbelegung 13 des Tragkörpers 2 und damit mit den inneren Kontaktflächen 8 und 9 kontaktiert. Die Elastomere 20 der Steckkontakte 15 und 16 stehen mit den äußeren Kontaktflächen 6 und 7 in elektrischer Verbindung.

Für das Betätigen des piezoelektrischen Biegewandlers 1 wird über einen Stecker 24 eine Verbindung zu einem externen Steuergerät hergestellt. Der Stecker 24 weist hierzu Kontaktstifte 26, 27 und 28 auf, welche in die Steckkontakte 15, 16 bzw. 17 eingesteckt werden können. Das Elastomer 20 der Steckkontakte 15, 16 und 17 umschließt dabei durch plastische Verformung den jeweiligen Kontaktstift 26, 27 bzw. 28, wodurch eine sichere elektrische Verbindung hergestellt wird. Durch die reversible Verformbarkeit des Elastomers kann die Steckverbindung mehrfach gelöst und wieder hergestellt werden, ohne daß eine Einbuße hinsichtlich der elektrischen Verbindung auftritt. Bei Untersuchungen mit Silikonkautschuk als Elastomer 20, war nach 50-maligem Lösen und Schließen der Steckverbindung keinerlei Einbuße hinsichtlich der elektrischen Verbindung feststellbar.

Der Stecker 24 selbst weist eine Platine 25 auf, auf welcher neben den Kontaktstiften 26, 27 und 28 verschiedene Elektronikbauteile 30 und 31 angeordnet sind. Die Platine 25 ist dafür vorgesehen, die über ein Anschlußkabel 32 zugeführten Steuersignale einer externen Steuereinheit in Leistungssignale für das Betätigen des piezoelektrischen Biegewandlers 1 umzuwandeln.

Zum Betätigen des piezoelektrischen Biegewandlers 1 wird in Polarisationsrichtung der Piezokeramiken an die Steckkontakte 15 und 16 eine Spannung von ca. 200 V angelegt. An den Steckkontakt 17, welcher die inneren Kontaktflächen 8 und 9 kontaktiert, wird abwechselnd zur Auslenkung des freien Endes des piezoelektrischen Biegewandlers 1 das Potential des Steckkontaktes 15 und das Potential des Steckkontaktes 16 gelegt. Auf diese Weise sieht einmal die Piezokeramik der piezoelektrischen Beschichtung 5 und das andere Mal die Piezokeramik der piezoelektrischen Beschichtung 4 ein elektromagnetisches Feld in ihrer Polarisationsrichtung und kontrahiert. Das freie Ende des Biegewandlers 1 biegt sich entsprechend den eingezeichneten Pfeilen einmal nach links und einmal nach rechts.

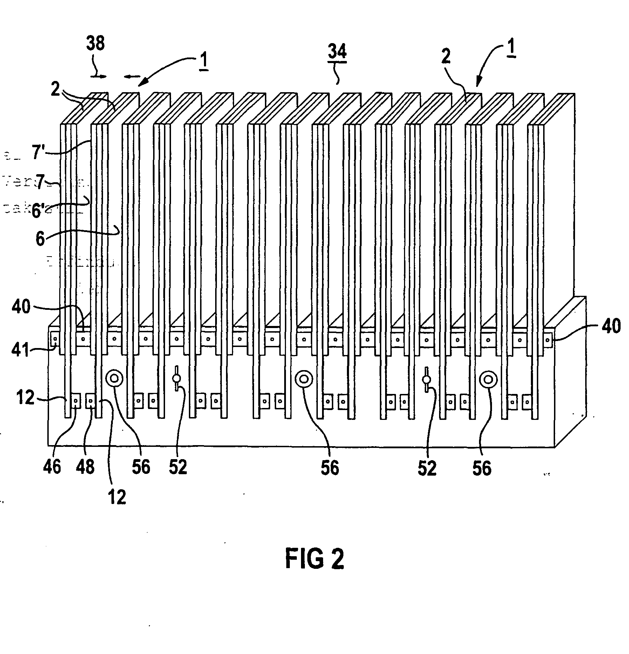

In FIG 2 ist ein Modul 34 aus sechzehn parallel angeordneten Biegewandlern 1 gezeigt. Die piezoelektrischen Biegewandler 1 sind hierbei in gleicher Weise aufgebaut wie der in FIG 1 gezeigte. Es ist dabei lediglich der Anschlußsockel 10 zu einer gemeinsamen Anschlußleiste 36 zusammengefaßt. Jeder Tragkörper 2 ist dabei wiederum über die piezoelektrische Beschichtung hinaus in die Anschlußleiste 36 geführt. Piezoelektrische Beschichtung und das freie Ende 12 des Tragkörpers 2 der piezoelektrischen Biegewandler 1 sind an der Aussparung der Anschlußleiste 36 eingesteckt und mit der Anschlußleiste 36 verklebt.

Ausgehend von FIG 1 sind benachbarte piezoelektrische Biegewandler 1 des Moduls 34 entsprechend der Polarisationsrichtung 38 der piezokeramischen Beschichtung jeweils um 180 Grad gegeneinander gedreht. Bei dem bereits beschriebenen Betrieb der piezoelektrischen Biegewandler 1 befinden sich daher die benachbarten äußeren Kontaktflächen 6' und 7' auf demselben elektrischen Potential. Aus diesem Grund sind benachbarte äußere Kontaktflächen der piezoelektrischen Biegewandler 1 des Moduls 34 über einen gemeinsamen elektrischen Steckkontakt 40 kontaktierbar. Aufeinander folgende Steckkontakte 41, 40 werden abwechselnd auf unterschiedliches Potential gelegt. Zur Herstellung der elektrischen Steckkontakte für die Kontaktierung der äußeren Kontaktflächen der elektrischen Biegewandler 1 weist die Anschlußleiste 36 des Moduls 34 einen Querkanal 42 auf. Dieser Querkanal 42 wird nach Einsetzen der beschichteten Tragkörper 2 in voneinander getrennte Kammern unterteilt, welche nach Auffüllen mit leitfähigem Silikonkautschuk die jeweiligen Steckkontakte bilden.

Zur Kontaktierung der Tragkörper 2 sind wie in FIG 1 gezeigt, elektrische Steckkontakte 46 und 48 ausgebildet. Dabei liegen die elektrischen Steckkontakte 46 und 48 einander direkt gegenüber, um auf der Anschlußleiste 36 Raum für Befestigungselemente zu bilden. So weist die Anschlußleiste 36 gemäß FIG 2 Bohrungen 50 zum Befestigen an ein Gehäuse sowie Arretierstifte 52 zum Fixieren der Lage des Moduls 34 in einem Gehäuse auf.

Das gezeigt Modul 34 eignet sich insbesondere zur Weitergabe der Musterinformation an die Nadeln einer Wirk- oder Strickmaschine. Je nach Stellung der freien Enden der piezoelektrischen Biegewandler 1 wird die dem Biegewandler zugeordnete Nadel zum Stricken oder Wirken herangezogen oder nicht. Prinzipiell kann das gezeigte Modul 34 aber auch für jede andere Anwendung verwendet werden, bei welcher eine elektronische Information in eine mechanisch abtastbare Information umgewandelt werden muß.

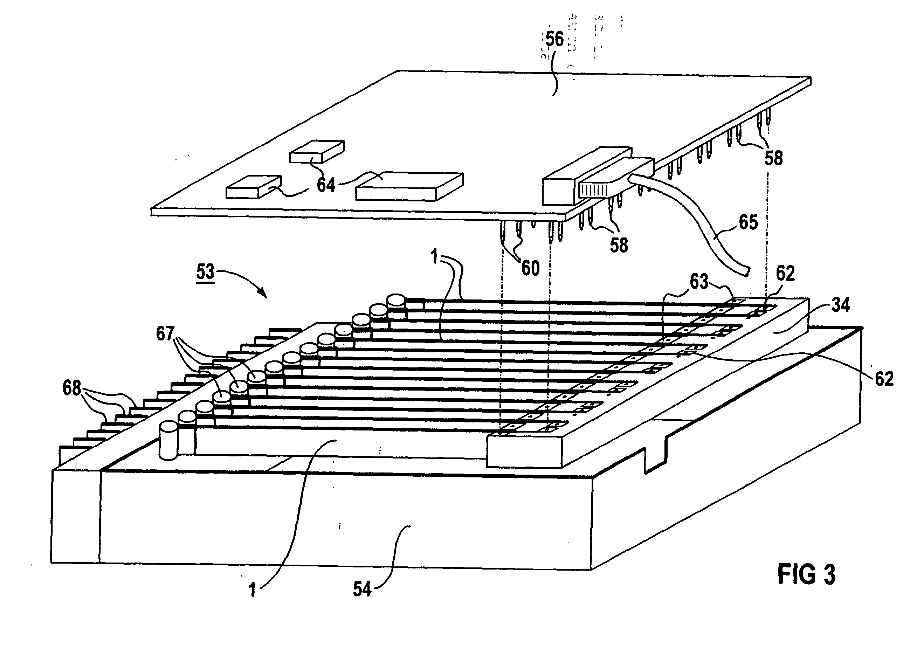

Zum Ansteuern des Moduls 34 gemäß FIG 2 ist eine, hier nicht dargestellte, mit einer entsprechenden Leistungselektronik ausgestattete Elektronikplatine vorgesehen, welche mit entsprechenden Kontaktstiften in die elektrischen Steckkontakte-40, 41, 46, 48 der Anschlußleiste 36 eingreift (siehe hierzu auch Figur 3). Die Elektronik der Platine wandelt dabei entsprechende Steuersignale in Leistungssignale zum Betätigen der piezoelektrischen Biegewandler 1 um. Das freie Ende jedes piezoelektrischen Biegewandlers 1 des gezeigten Moduls 34 kann prinzipiell in drei definierte Zustände gebracht werden. Zustand I entspricht der Auslenkung nach links, Zustand III der Auslenkung nach rechts und Zustand II dem Ruhezustand des piezoelektrischen Biegewandlers 1.

FIG 3 zeigt ein modulartig aufgebautes Steuermodul 53 für die Steuerung der Nadeln einer Rundstrickmaschine. Das Steuermodul 53 setzt sich zusammen aus einem Gehäuse 54, dem Modul 34 gemäß FIG 2 und der Platine 56 zum Betätigen der piezoelektrischen Biegewandler 1 des Moduls 34. Die Platine 56 verfügt über elektrische Kontaktstifte 58 und 60, welche in die entsprechenden Steckkontakte 62 und 63 des Moduls 34 einsteckbar sind. Auf der Platine 56 ist desweiteren eine Elektronikschaltung mit verschiedenen Elektronikbauteilen 64 angeordnet, welche die über ein Verbindungskabel 65 von einer externen Steuereinheit empfangenen Steuersignale in Leistungssignale für die piezoelektrischen Biegewandler 1 des Moduls 34 umwandelt.

Aus Gründen der Übersichtlichkeit ist der Deckel des Gehäuses 54 nicht miteingezeichnet.

Die piezoelektrischen Biegewandler 1 weisen an ihrem freien beweglichen Ende jeweils eine aufgeklebte zylinderförmige Verdickung 67 auf. Die Verdickung 67 greift jeweils in den hinteren Teil einer beweglich am Gehäuse 54 angeordneten, hier nicht dargestellten, Wippe ein. Der vordere Teil dieser Wippe ist als ein Steueranker 68 ausgebildet, dessen Stellung letztendlich von der Steuerplatine der Rundstrickmaschine abgetastet wird.

Der modulare Aufbau des Steuermoduls 53 erlaubt einen raschen und problemlosen Austausch der einzelnen Komponenten. Durch die Ausbildung der elektrischen Anschlüsse als Steckkontakte 62, 63 verringert sich gegenüber einem herkömmlichen Steuermodul, wobei jeder einzelne piezoelektrische Biegewandler 1 mit separaten Anschlußdrähten und Lötkontakten versehen ist, die Zahl der Ausfallkomponenten. Desweiteren kann der Zusammenbau des Steuermoduls 53 vollständig automatisiert werden. Ein Handverlöten von Anschlußdrähten ist nicht mehr erforderlich. Die Elastomer-Steckkontakte 62, 63 gewährleisten einen sicheren, langlebigen und wartungsfreien Betrieb des gesamten Steuermoduls 53.

## Patentansprüche

1. Piezoelektrischer Biegewandler (1) mit einem flachen Tragkörper (2) und einer darauf zumindest einseitig aufgebrachten piezoelektrisch aktiven Beschichtung (4,5) mit einer inneren, dem Tragkörper (2) zugewandten Kontaktfläche (8, 9) und einer äußeren, dem Tragkörper (2) abgewandten Kontaktfläche (6,7), der ein die Kontaktfläche (6,7,8,9) berührendes, elektrisch leitfähiges Elastomer (20) aufweist,
**gekennzeichnet durch** einen elektrischen Steckkontakt (15,16,17) zur Kontaktierung der Kontaktflächen (6, 7, 8, 9), wobei in das elektrisch leitfähige Elastomer (20) ein Kontaktstift (26,27,28) unter elastischer Verformung einführbar ist.

2. Piezoelektrischer Biegewandler (1) nach Anspruch 1,
**dadurch gekennzeichnet, daß** sein eines Ende fest mit einem Anschlußsockel (10) verbunden ist, wobei das Elastomer (20) eine Bohrung oder eine Aussparung des Anschlußsockels (10) ausfüllt, wobei das Elastomer (20) zum Einstecken des Kontaktstiftes (26,27,28) eine frei zugängliche Oberfläche aufweist und wobei zumindest ein Teil der Wandung der Bohrung oder der Aussparung durch einen Teil der Kontaktfläche (6,7,8,9)gebildet ist.

3. Piezoelektrischer Biegewandler (1) nach Anspruch 1 oder 2,
**dadurch gekennzeichnet, daß** das Elastomer (20) ein Silikonkautschuk mit eingelagerten metallischen Partikeln, insbesondere aus Silber, ist.

4. Piezoelektrischer Biegewandler (1) nach Anspruch 1 oder 2,
**dadurch gekennzeichnet, daß** das Elastomer (20) ein leitfähiger Kunststoffschaum ist.

5. Piezoelektrischer Biegewandler (1) nach einem der Ansprüche 2 bis 4,
**dadurch gekennzeichnet, daß** die äußere und innere Kontaktfläche (6,7,8,9) den elektrischen Steckkontakt (15,16,17) mit einem Elastomer (20) aufweisen, wobei sich die innere Kontaktfläche (8,9) zusammen mit dem Tragkörper (2) über die Beschichtung hinaus in Längsrichtung des Tragkörpers (2) in den Anschlußsockel (10) erstreckt und dort über das Elastomer (20) kontaktierbar ist.

6. Piezoelektrischer Biegewandler (1) nach einem der Ansprüche 1 bis 5,
**dadurch gekennzeichnet, daß** er beidseitig mit der piezoelektrisch aktiven Beschichtung (4,5) mit jeweils einer äußeren Kontaktfläche (6,7) versehen ist.

7. Piezoelektrischer Biegewandler (1) nach einem der Ansprüche 1 bis 6,
**dadurch gekennzeichnet, daß** der Tragkörper (2) aus einem elektrisch leitfähigen Material besteht und selbst die innere Kontaktfläche (6,7) bildet.

8. Modul (34) mit einer Anzahl von piezoelektrischen Biegewandlern (1) nach einem der vorhergehenden Ansprüche,
**dadurch gekennzeichnet, daß** die einen Enden der Biegewandler (1) in einer gemeinsamen Anschlußleiste (36) zusammengefaßt sind, und daß das Elastomer (20) in einer Bohrung oder einer Aussparung der Anschlußleiste (36) angeordnet ist.

9. Modul (34) nach Anspruch 8,
**gekennzeichnet durch** beidseitig mit jeweils einer Piezokeramik beschichtete Biegewandler (1), wobei die Polarisationsrichtungen (38) der Piezokeramiken eines Biegewandlers (1) jeweils in die gleiche Richtung und die Polarisationsrichtungen (38) einander zugewandter Piezokeramiken benachbarter Biegewandler (1) in entgegengesetzte Richtungen zeigen, wobei die einander zugewandten äußeren Kontaktflächen (6,7) der Piezokeramiken benachbarter Biegewandler (1) gemeinsam mit einem Elastomer (20) kontaktiert sind.

10. Modul (34) nach Anspruch 8 oder 9,
**dadurch gekennzeichnet, daß** jeder Tragkörper (2) aus einem elektrisch leitfähigen Material besteht, daß sich jeder Tragkörper (2) über die Beschichtung hinaus in die Anschlußleiste (36) erstreckt und dort den elektrischen Steckkontakt (40,41,46,48,62,63) in Form des Elastomers aufweist.

## Claims

1. Piezoelectric bending converter (1) with a flat carrying body (2) and a piezoelectrically active coating (4, 5) applied thereto on at least one side, with an inner contact face (8, 9) facing the carrying body (2) and an outer contact face (6, 7) facing away from the carrying body (2), which has an electrically conducting elastomer (20) touching the contact face (6, 7, 8, 9),
**characterised by** an electric plug (15, 16, 17) for contacting the contact faces (6, 7, 8, 9), wherein a contact pin (26, 27, 28) can be inserted into the electrically conducting elastomer (20) with elastic deformation.

2. Piezoelectric bending converter (1) according to claim 1,
**characterised in that** one of its ends is firmly connected to a connecting socket (10), wherein the elastomer (20) fills a bore or a recess of the connecting socket (20), the elastomer (20) having a freely accessible surface for inserting the contact pin (26, 27, 28) and at least one section of the wall of the bore or the recess being formed by a section of the contact face (6, 7, 8, 9).

3. Piezoelectric bending converter (1) according to claim 1 or 2,
**characterised in that** the elastomer (20) is a natural silicon rubber with embedded metal particles, in particular of silver.

4. Piezoelectric bending converter (1) according to claim 1 or 2,
**characterised in that** the elastomer (20) is a conducting plastics material foam.

5. Piezoelectric bending converter (1) according to one of claims 2 to 4,
**characterised in that** the
outer and inner contact faces (6, 7, 8, 9) have the electric plug (15, 16, 17) with an elastomer (20), wherein the inner contact face (8, 9) extends together with the carrying body (2) beyond the coating in the longitudinal direction of the carrying body (2) into the connecting socket (10) and is there contactable via the elastomer (20).

6. Piezoelectric bending converter (1) according to one of claims 1 to 5,
**characterised in that** it is fitted with the piezoelectrically active coating (4, 5) on both sides with an outer contact face (6, 7) in each case.

7. Piezoelectric bending converter (1) according to one of claims 1 to 6,
**characterised in that** the carrying body (2) consists of an electrically conducting material and itself forms the inner contact face (6, 7).

8. Module (34) with a number of piezoelectric bending converters (1) according to one of the preceding claims,
**characterised in that** one end of each of the bending converters (1) are combined into a joint connector strip (36) and **in that** the elastomer (20) is arranged in a bore or a recess of the connector strip (36).

9. Module (34) according to claim 8,
**characterised by** bending converters (1) coated on both sides with a piezoceramic in each case, wherein the polarisation directions (38) of the piezoceramics of a bending converter (1) point in each case in the same direction and the polarisation directions (38) of piezoceramics of adjacent bending converters (1) facing one another point in opposite directions, wherein the outer contact faces (6, 7) of the piezoceramics of adjacent bending converters (1) facing one another are contacted jointly with an elastomer (20).

10. Module (34) according to claim 8 or 9,
**characterised in that** each carrying body (2) consists of an electrically conducting material, **in that** each carrying body (2) extends beyond the coating into the connector strip (36) and there comprises the electric plug (40, 41, 46, 48, 62, 63) in the form of the elastomer.

## Revendications

1. Transducteur (1) piézoélectrique en flexion, comprenant une embase (2) plate et un revêtement (4, 5) piézo-électriquement actif qui y est déposé au moins d'un côté, et qui a une surface(8, 9) de contact intérieure tournée vers l'embase (2) et une surface (6, 7) de contact extérieure, qui est éloignée de l'embase (2), le transducteur comportant un élastomère (20) conducteur de l'électricité et touchant la surface (6, 7, 8, 9) de contact,
**caractérisé par** un contact (15, 16, 17) électrique à enfichage pour la mise en contact des surfaces (6, 7, 8, 9) de contact, dans lequel une broche (26, 27, 28) de contact peut être introduite avec déformation élastique dans l'élastomère (20) conducteur de l'électricité.

2. Transducteur (1) piézo-électrique en flexion suivant la revendication 1, **caractérisé en ce que** son extrémité est reliée rigidement à un socle (10) de connexion, l'élastomère (20) remplissant un trou ou un évidemment du socle (10) de connexion, l'élastomère (20) ayant pour l'enfichage de la broche (26, 27, 28) de contact une surface librement accessible et au moins une partie de la paroi du trou ou de l'évidemment étant formée par une partie de la surface (6, 7, 8, 9) de contact.

3. Transducteur (1) piézo-électrique en flexion suivant la revendication 1 ou 2,
**caractérisé en ce que** l'élastomère (20) est un caoutchouc de silicone ayant des particules métalliques, notamment en argent, qui y sont incorporées.

4. Transducteur (1) piézo-électrique en flexion suivant la revendication 1 ou 2, **caractérisé en ce que** l'élastomère (20) est une mousse de plastique conductrice.

5. Transducteur (1) piézo-électrique en flexion suivant l'une des revendications 2 à 4, **caractérisé en ce que** les surfaces (6, 7, 8, 9) extérieures et intérieures de contact comportent le contact (15, 16, 17) à enfichage à connecteur ayant un élastomère (20), la surface(8, 9) intérieure de contact s'étendant dans le socle (10) de connexion, ensemble avec l'embase (2) au delà du revêtement dans la direction longitudinale de l'embase (2) et pouvant y être mise en contact par l'élastomère (20).

6. Transducteur (1) piézo-électrique en flexion suivant des revendications 1 à 5, **caractérisé en ce qu'**il est muni des deux côtés d'un revêtement (4, 5) actif piézo-électriquement ayant respectivement une surface (6, 7) de contact extérieure.

7. Transducteur (1) piézo-électrique en flexion suivant l'une des revendications 1 à 6, **caractérisé en ce que** l'embase (2) est en un matériau conducteur de l'électricité et forme soi-même une surface (6, 7) intérieure de contact.

8. Module (34) ayant un certain nombre de transducteurs (1) piézo-électriques en flexion suivant l'une des revendications précédentes, **caractérisé en ce que** les unes des extrémités du transducteur (1) en flexion sont rassemblées en une baguette (36) commune de connexion et **en ce que** l'élastomère (20) est disposé dans un trou ou dans un évidemment de la baguette (36) de connexion.

9. Module (34) suivant la revendication 8, **caractérisé par** des transducteurs (1) en flexion revêtu des deux côtés respectivement d'une céramique piézo-électrique, les sens (38) de polarisation des céramiques piézo-électriques d'un transducteur (1) en flexion étant respectivement les mêmes, et les sens (38) de polarisation de céramiques piézo-électriques tournées l'une vers l'autre de transducteur (1) en flexion voisin étant dirigés dans des sens opposés, les surfaces (6, 7) extérieures de contact tournées l'une vers l'autre des céramiques piézo-électriques de transducteur (1) en flexion voisins étant mises en contact commun avec un élastomère (20).

10. Module (34) suivant les revendications 8 ou 9,
**caractérisé en ce que** chaque embase (2) est en un matériau conducteur de l'électricité, **en ce que** chaque embase (2) s'étend au-delà du revêtement dans la baguette (36) de connexion et y a le contact (40, 41, 46, 48, 62, 63) électrique à enfichage sous la forme de l'élastomère.
